# EUROPEAN PATENT APPLICATION

(11) **EP 4 037 441 A1**
(43) Date of publication of application: **03.08.2022**
(21) Application number: 20878686.3
(22) Date of filing: 12.10.2020
(51) Int. Cl.: H05K 1/02, H05K 1/11, H05K 1/18

(54) **CIRCUIT BOARD ASSEMBLY AND ELECTRONIC DEVICE**

(30) Priority: 21.10.2019 CN 201911000398
(71) Applicant: Huawei Technologies Co., Ltd., Longgang District Shenzhen, Guangdong 518129 (CN)
(72) Inventor: SHI, Hongbin, Shenzhen, Guangdong 518129 (CN)
(74) Representative: Maiwald Patent- und Rechtsanwaltsgesellschaft mbH
(86) International application number: PCT/CN2020/120338
(87) International publication number: WO 2021/078030

(57) **Abstract**

Embodiments of this application provide a circuit board assembly and an electronic device. The electronic device may include a mobile or fixed terminal, for example, a mobile phone, a tablet computer, a notebook computer, an ultra-mobile personal computer (UMPC), a handheld computer, a walkie-talkie, a netbook, a POS terminal, a personal digital assistant (PDA), an event data recorder, a wearable device, and a virtual reality device. A first redundant pad position is disconnected from a first bottom plate, and a first redundant pad is disposed in an area in which stress is easily concentrated on the first chip. When the first bottom plate is under stress, the stress is not concentrated on the first redundant pad position. This can improve reliability of the first chip. In addition, when the circuit board assembly is faulty, compared with that in a solution of filling an underfill in the conventional technology, the first chip is easy to detach, and therefore maintenance costs are relatively low.

## Description

This application claims priority to Chinese Patent Application No. 201911000398.8, filed with the China National Intellectual Property Administration on October 21, 2019 and entitled "CIRCUIT BOARD ASSEMBLY AND ELECTRONIC DEVICE", which is incorporated herein by reference in its entirety.

### TECHNICAL FIELD

This application relates to the field of terminal technologies, and in particular, to a circuit board assembly and an electronic device.

### BACKGROUND

With the development of electronic technologies, assembly density of an integrated circuit board is increasingly high, solder joints in a microelectronic device are increasingly small, and a reliability requirement is increasingly high. In packaging technologies, such as wafer level chip scale package (Wafer Level Chip Scale Package, WLCSP) and flip chip chip scale package (Flip Chip Chip Scale Package, FCCSP), that are widely used in electronic packaging, an electrical connection and a mechanical connection between an electronic component and a substrate or a circuit board are implemented directly via solder joints.

Currently, for a circuit board assembly that is packaged in a WLCSP or FCCSP manner, in an actual use process, the circuit board is prone to undergo a temperature cycle process, or undergo a process such as a drop or a collision. In the foregoing cases, the circuit board is under stress, and this stress is easily transferred to the side of an electronic component via solder joints, causing damage to the electronic component. To avoid such a situation, an underfill with a relatively low coefficient of thermal expansion (coefficient of thermal expansion below glass-transition temperature < 30 ppm/°C) is usually applied to a solder joint gap between a chip and a substrate or between the electronic component and the circuit board, and silica micro-sphere granules are added to the interior of the underfill to reduce the coefficient of thermal expansion.

However, it is difficult to remove the underfill after curing, and therefore, the circuit board is difficult to maintain, or even cannot be detached or replaced. Consequently, maintenance costs of the chip or the circuit board are relatively high.

### SUMMARY

Embodiments of this application provide a circuit board assembly and an electronic device. For an area in which stress is easily concentrated on a chip, the area is disconnected from a first bottom plate, so that stress of the first bottom plate cannot be concentrated on a failure-prone area on the chip via solder joints, and a stress isolation function is implemented. In addition, when the circuit board assembly is faulty, the chip is easy to replace, and therefore maintenance costs are relatively low.

According to a first aspect, an embodiment of this application provides a circuit board assembly that is applied to an electronic device. The circuit board assembly includes a first chip, a first bottom plate, and a plurality of functional solder balls. An array of functional pads is disposed on a first surface of the first chip. A plurality of bottom plate pads are disposed on the first bottom plate. The functional pads are electrically connected to the corresponding bottom plate pads via the functional solder balls. The first chip is further provided with a redundant pad position. The redundant pad position is configured to dispose a redundant pad. The redundant pad position includes a first redundant pad position disconnected from the first bottom plate, to implement stress isolation between the first bottom plate and the first redundant pad position.

The first redundant pad position is disconnected from the first bottom plate. In this way, the first redundant pad position and a corresponding position of the first bottom plate are in a stress isolation state. The first redundant pad position is disposed in an area in which stress is easily concentrated on the first chip, for example, at a failure-prone position on the first chip. In this way, when the first bottom plate is under stress, the stress is not concentrated on the first redundant pad position. This can improve reliability of the circuit board assembly. In addition, when the circuit board assembly is faulty, compared with that in a solution of filling an underfill in the conventional technology, the first chip does not need to take out the underfill as in the conventional technology, and can be replaced only by using a conventional detachment means. Therefore, maintenance costs are relatively low.

In a possible implementation, a first redundant pad is further disposed on the first surface, the first redundant pad is connected to the first redundant pad position, and one end of the first redundant pad away from the first redundant pad position is disposed in a suspended manner.

One end of the first redundant pad away from the first redundant pad position is disposed in a suspended manner. In this way, there is space between the first redundant pad and the first bottom plate or between the first redundant pad and another component on the first bottom plate, and there is no other component in the space. Therefore, the first redundant pad position can be disconnected from the first bottom plate, to implement stress isolation between the two.

In a possible implementation, the bottom plate pads include a first bottom plate pad corresponding to the first redundant pad position, and one end of the first bottom plate pad away from the first bottom plate is disposed in a suspended manner.

One end of the first bottom plate pad far away from the first bottom plate is disposed in a suspended manner. In this way, there is space between the first bottom plate pad and the first redundant pad position or between the first bottom plate pad and another component disposed at the first redundant pad position, and there is no other component in the space. Therefore, the first redundant pad position can be disconnected from the first bottom plate, to implement stress isolation between the two.

In a possible implementation, a redundant solder ball is further included. A first redundant pad is further disposed on the first surface. The first redundant pad is connected to the first redundant pad position, the redundant solder ball is connected to the first redundant pad, and one end of the redundant solder ball away from the first redundant pad is disconnected from the first bottom plate.

One end of the redundant solder ball away from the first redundant pad is disconnected from the bottom plate. In this way, there is space between the redundant solder ball and the first bottom plate or between the redundant solder ball and another component on the first bottom plate, and there is no other component in the space. Therefore, the first redundant pad position can be disconnected from the first bottom plate, to implement stress isolation between the two.

In a possible implementation, a solder mask layer is disposed at a position that is on the first bottom plate and opposite to the first redundant pad.

The solder mask layer is disposed on the first bottom plate, so that water vapor, impurities, and the like in an external environment can be prevented from entering the first bottom plate.

In a possible implementation, a redundant solder ball and a solder mask layer are further included. A first redundant pad is further disposed on the first surface. The bottom plate pads includes a first bottom plate pad corresponding to the first redundant pad. The first redundant pad is connected to the first redundant pad position. The redundant solder ball is connected to the first redundant pad. The first bottom plate pad is connected to the first bottom plate. The solder mask layer is connected to the first bottom plate pad, and the redundant solder ball is in contact with the solder mask layer.

The solder mask layer is disposed between the redundant solder ball and the first bottom plate pad. Therefore, in a soldering process, the redundant solder ball cannot be connected to the first bottom plate pad. In this way, the redundant solder ball is disconnected from the first bottom plate pad, stress cannot be transferred between the two, and therefore, the stress on the first bottom plate cannot be concentrated on the first redundant pad position.

In a possible implementation, the first bottom plate is a printed circuit board or a package substrate.

When the first bottom plate is the printed circuit board, the first chip may be packaged in a wafer level chip scale package manner. When the first bottom plate is the package substrate, the first chip may be packaged in a flip chip chip scale package manner.

In a possible implementation, when the first bottom plate is the printed circuit board, the functional pads and the redundant pad are disposed on the first chip by using a rewiring layer, the rewiring layer includes two dielectric layers and a rewiring metal that are disposed on the first chip, the rewiring metal is sandwiched between the two dielectric layers, and the rewiring metal is configured to connect an original pad disposed on the first chip to the functional pads and the redundant pad.

By disposing the rewiring layer, chips at the four edges of a pad may be converted into the first chips facing a solder ball array. Finally, the original pad is rearranged.

In a possible implementation, when the first bottom plate is the package substrate, the circuit board assembly further includes a first printed circuit board, and the package substrate is connected to the first printed circuit board.

In a possible implementation, a second chip and a plurality of second functional solder balls are further included. An array of second functional pads is disposed on the second chip. A plurality third pads are disposed on a second surface of the first chip away from the first bottom plate. The second functional pads are electrically connected to the corresponding third pads via the second functional solder balls. The second chip is further provided with a second redundant pad position. The second redundant pad position is configured to dispose a redundant pad. The second redundant pad position includes a third redundant pad position, and the third redundant pad position is disconnected from the first chip, to implement stress isolation between the first chip and the third redundant pad position.

The second chip is disposed above the first chip, and the stress isolation between the first chip and the third redundant pad position is implemented. In this way, the third redundant pad position and a corresponding position of the first chip are in a stress isolation state. The third redundant pad position is disposed in an area in which stress is easily concentrated on the third chip, for example, at a failure-prone position on the third chip. In this way, when the first chip is under stress, the stress is not transferred to and concentrated on the third redundant pad position. This can improve reliability of the circuit board assembly. In addition, when the circuit board assembly is faulty, compared with that in a solution of filling an underfill in the conventional technology, the second chip is easy to detach, and therefore maintenance costs are relatively low.

According to a second aspect, an embodiment of this application provides an electronic device, including at least a display, a middle frame, a rear cover, and the circuit board assembly according to any one of the claims. The display and the rear cover are respectively located on two sides of the middle frame, and the circuit board assembly is located in a cavity enclosed by the display, the rear cover, and the middle frame.

The first redundant pad position is disconnected from the first bottom plate, and the first redundant pad position is disposed in an area in which stress is easily concentrated on the first chip. In this way, when the first bottom plate is under stress because the electronic device falls, or the like, the stress is not transferred to and concentrated on the first redundant pad position. This can improve reliability of the circuit board assembly. In addition, when the circuit board assembly is faulty, compared with that in a solution of filling an underfill in the conventional technology, the first chip is easy to detach, and therefore maintenance costs are relatively low.

### BRIEF DESCRIPTION OF DRAWINGS

FIG. 1 is a schematic diagram of a three-dimensional structure of an electronic device according to an embodiment of this application;
FIG. 2 is a schematic diagram of an exploded structure of an electronic device according to an embodiment of this application;
FIG. 3 is a schematic diagram of a structure in which a circuit board assembly of an electronic device is mounted on a middle frame according to an embodiment of this application;
FIG. 4 is an enlarged view of an internal structure when a chip fails in the conventional technology;
FIG. 5 is a schematic diagram of a structure in which a first chip of a circuit board assembly of an electronic device keeps connected to a first bottom plate according to an embodiment of this application;
FIG. 6A is a schematic diagram of a case in which one end of a first redundant pad of an electronic device is disposed in a suspended manner according to an embodiment of this application;
FIG. 6B is a schematic diagram of a case in which one end of a first redundant pad of an electronic device is disposed in a suspended manner according to an embodiment of this application;
FIG. 6C is a schematic diagram of a case in which one end of a first redundant pad of an electronic device is disposed in a suspended manner according to an embodiment of this application;
FIG. 6D is a schematic diagram of a case in which one end of a first redundant pad of an electronic device is disposed in a suspended manner according to an embodiment of this application;
FIG. 7A is a schematic diagram of a case in which a redundant solder ball of an electronic device is disconnected from a first bottom plate according to an embodiment of this application;

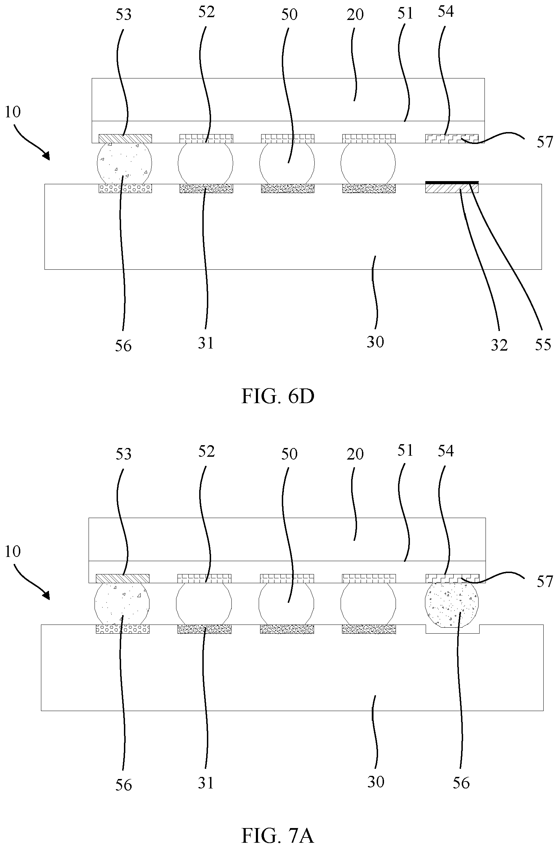

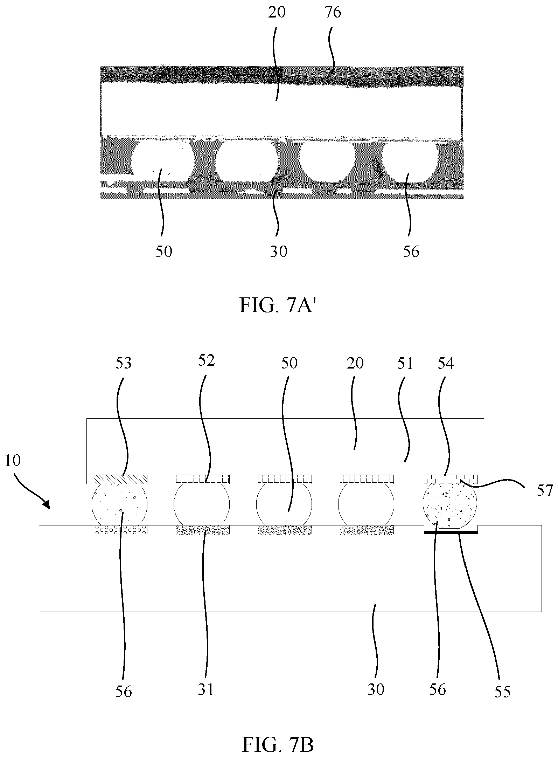

FIG. 7A' is a picture diagram of a case in which a redundant solder ball of an electronic device is disconnected from a first bottom plate according to an embodiment of this application;
FIG. 7B is a schematic diagram of a case in which a redundant solder ball of an electronic device is disconnected from a first bottom plate according to an embodiment of this application;

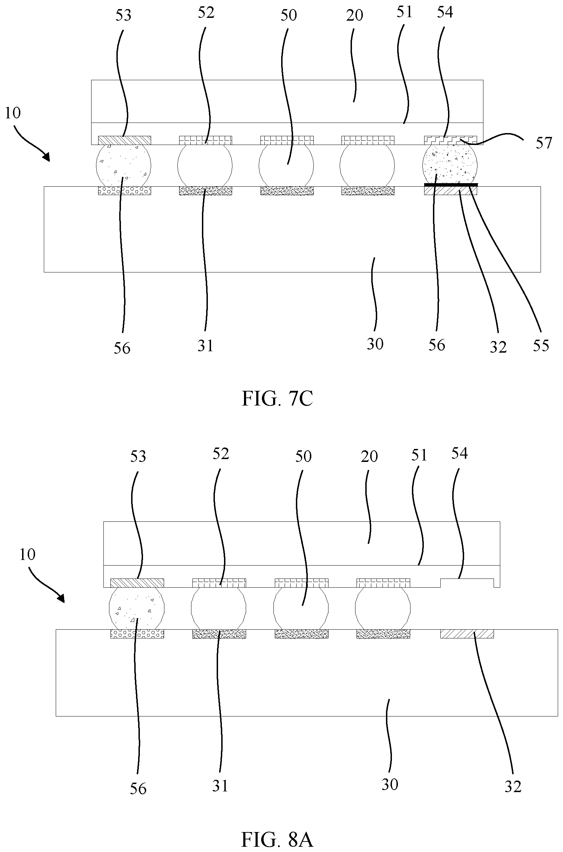

FIG. 7C is a schematic diagram showing that a redundant solder ball of an electronic device is connected to a first bottom plate pad by using a solder mask layer according to an embodiment of this application;
FIG. 8A is a schematic diagram showing that a first bottom plate pad of an electronic device is disposed in a suspended manner according to an embodiment of this application;

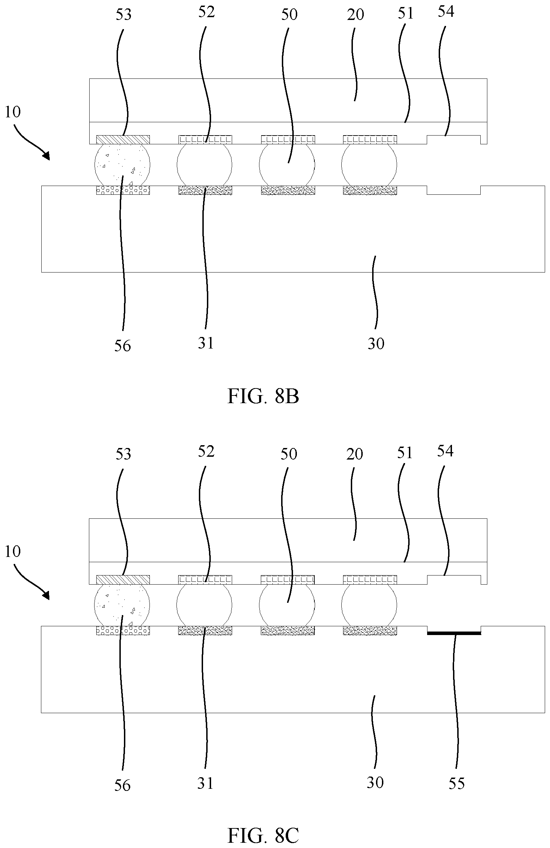

FIG. 8B is a schematic diagram showing that no component is disposed between a first redundant pad position and a first bottom plate of an electronic device according to an embodiment of this application;
FIG. 8C is a schematic diagram showing that a solder mask layer is disposed between a first redundant pad position and a first bottom plate of an electronic device according to an embodiment of this application;

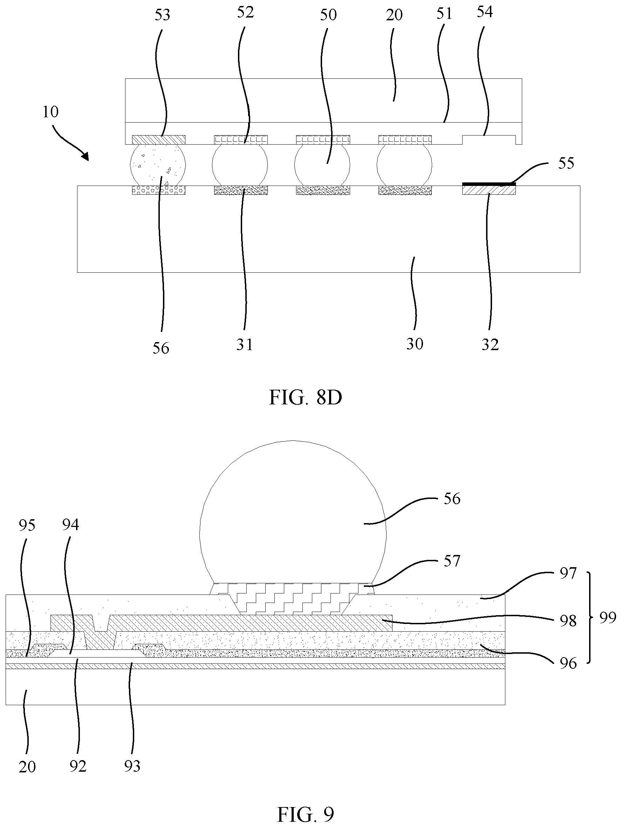

FIG. 8D is a schematic diagram showing that a solder mask layer and a first bottom plate pad are disposed between a first redundant pad position and a first bottom plate of an electronic device according to an embodiment of this application;
FIG. 9 is a schematic diagram of a package structure in which a first chip in an electronic device is packaged in a WLCSP manner according to an embodiment of this application;

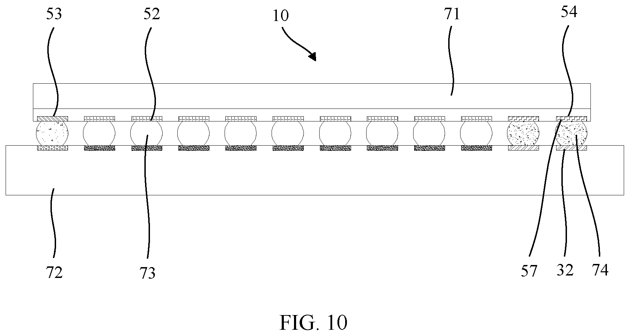

FIG. 10 is a schematic diagram of a structure of a circuit board assembly in the conventional technology;

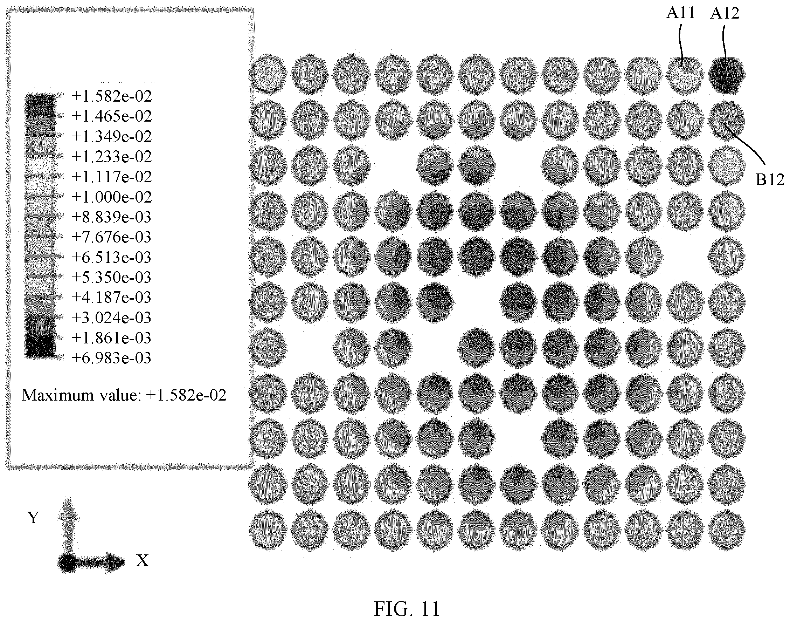

FIG. 11 is a diagram of a simulation result of a circuit board assembly in the conventional technology;

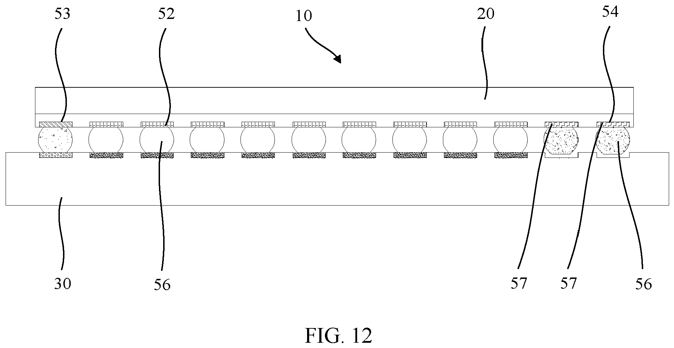

FIG. 12 is a schematic diagram of a structure of a circuit board assembly of an electronic device according to an embodiment of this application;

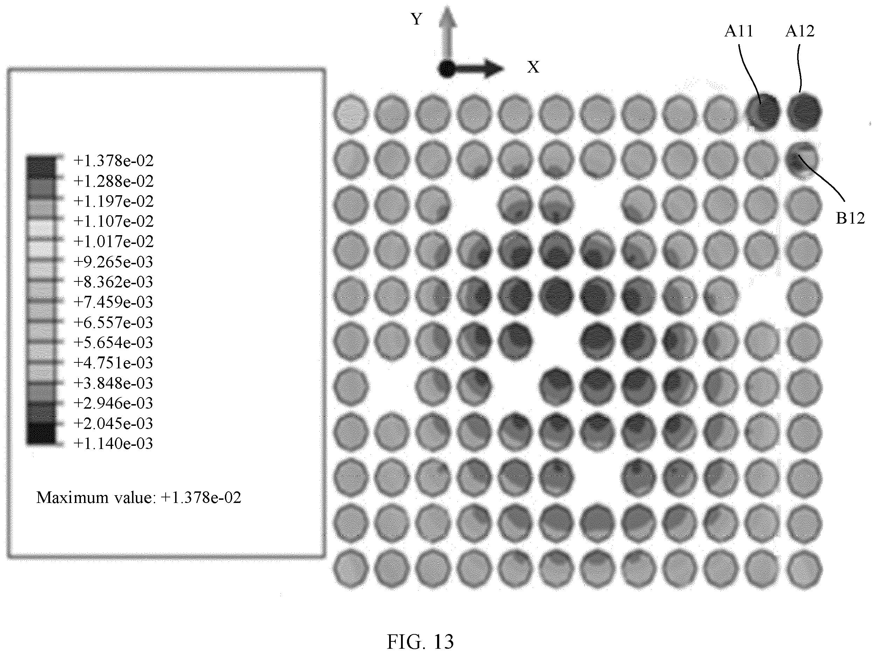

FIG. 13 is a diagram of a simulation result of a circuit board assembly of an electronic device according to an embodiment of this application;

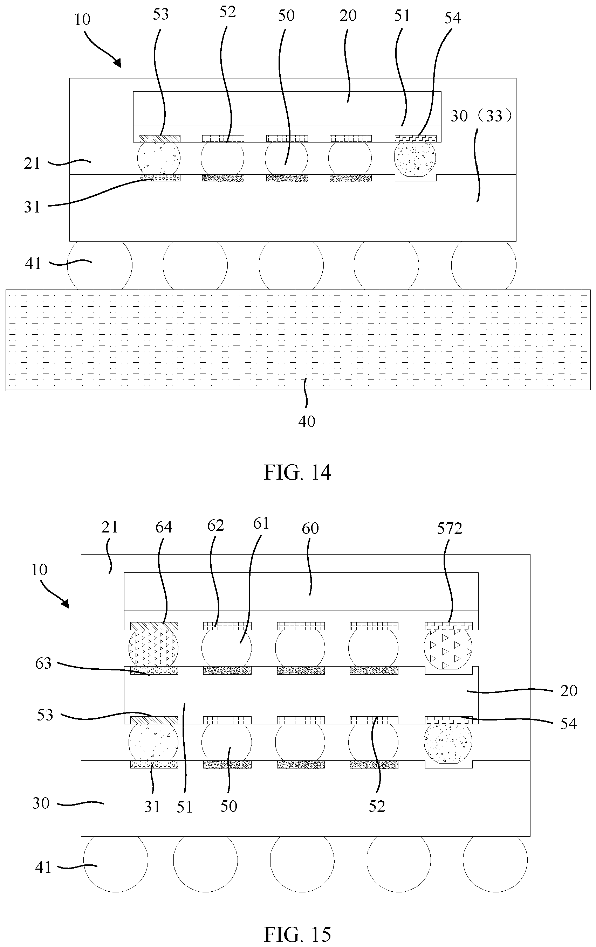

FIG. 14 is a schematic diagram of a structure of a circuit board assembly of an electronic device according to an embodiment of this application;
FIG. 15 is a schematic diagram of a structure of a circuit board assembly of an electronic device according to an embodiment of this application;

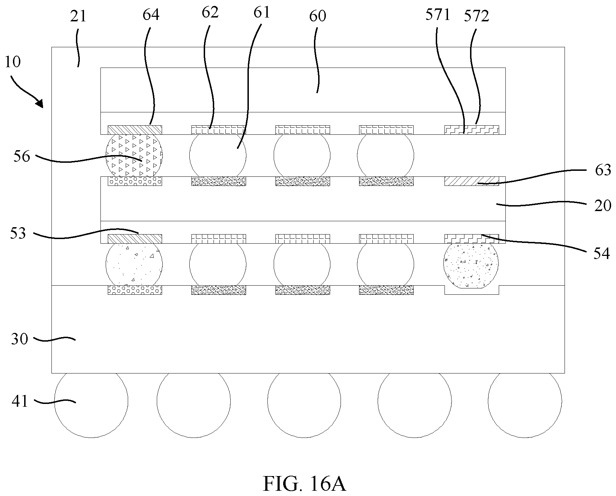

FIG. 16A is a schematic diagram of a case in which one end of a second redundant pad of an electronic device is disposed in a suspended manner according to an embodiment of this application;

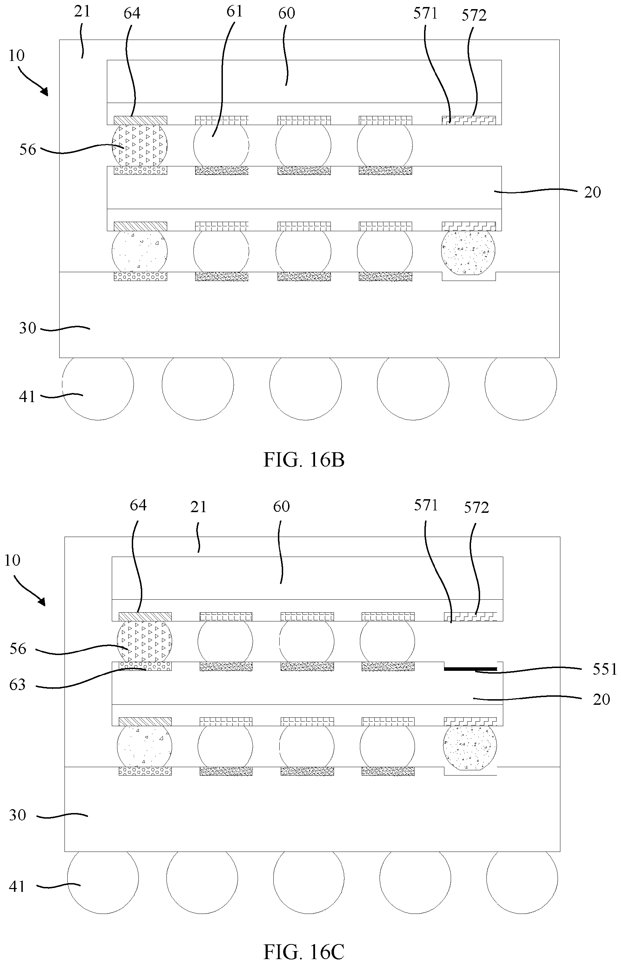

FIG. 16B is a schematic diagram of a case in which one end of a second redundant pad of an electronic device is disposed in a suspended manner according to an embodiment of this application;
FIG. 16C is a schematic diagram of a case in which one end of a second redundant pad of an electronic device is disposed in a suspended manner according to an embodiment of this application;

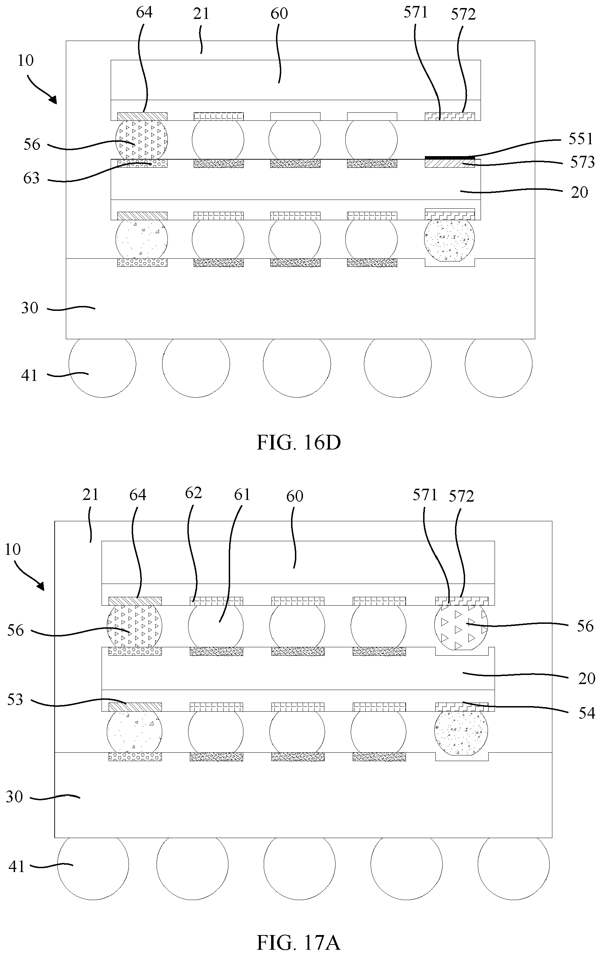

FIG. 16D is a schematic diagram of a case in which one end of a second redundant pad of an electronic device is disposed in a suspended manner according to an embodiment of this application;
FIG. 17A is a schematic diagram of a case in which a second redundant solder ball of an electronic device is disconnected from a first chip according to an embodiment of this application;

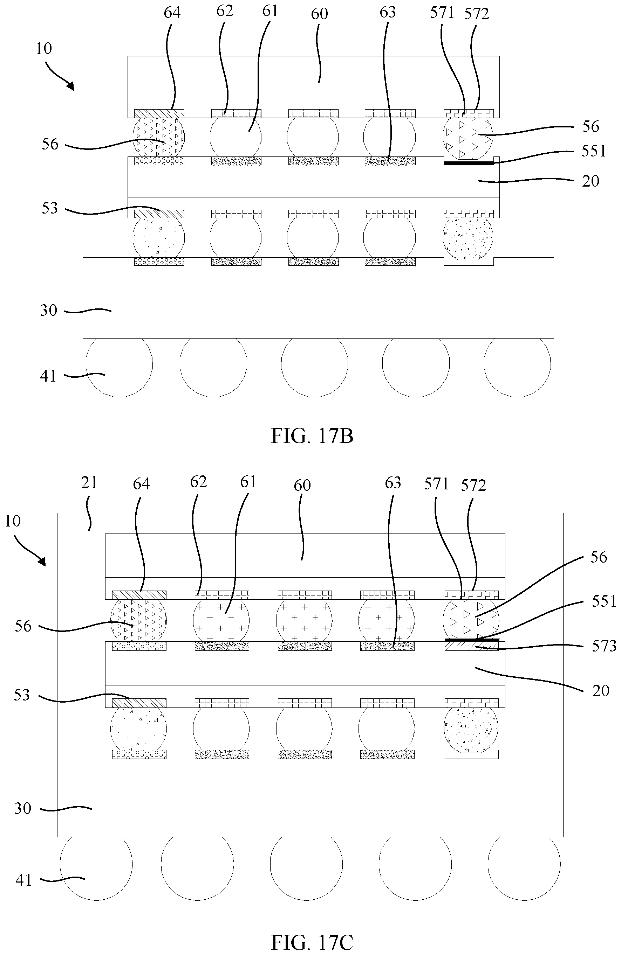

FIG. 17B is a schematic diagram of a case in which a second redundant solder ball of an electronic device is disconnected from a first chip according to an embodiment of this application;
FIG. 17C is a schematic diagram showing that a second redundant solder ball of an electronic device is connected to a first chip pad by using a second solder mask layer according to an embodiment of this application;

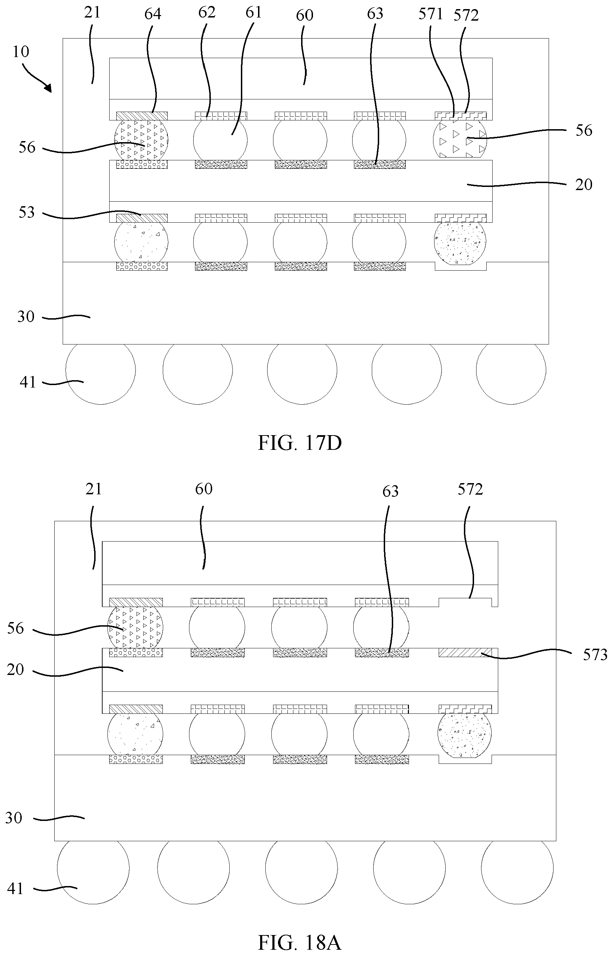

FIG. 17D is a schematic diagram showing that a second redundant solder ball of an electronic device is disconnected from a first chip according to an embodiment of this application;
FIG. 18A is a schematic diagram showing that a third pad of an electronic device is disposed in a suspended manner according to an embodiment of this application;

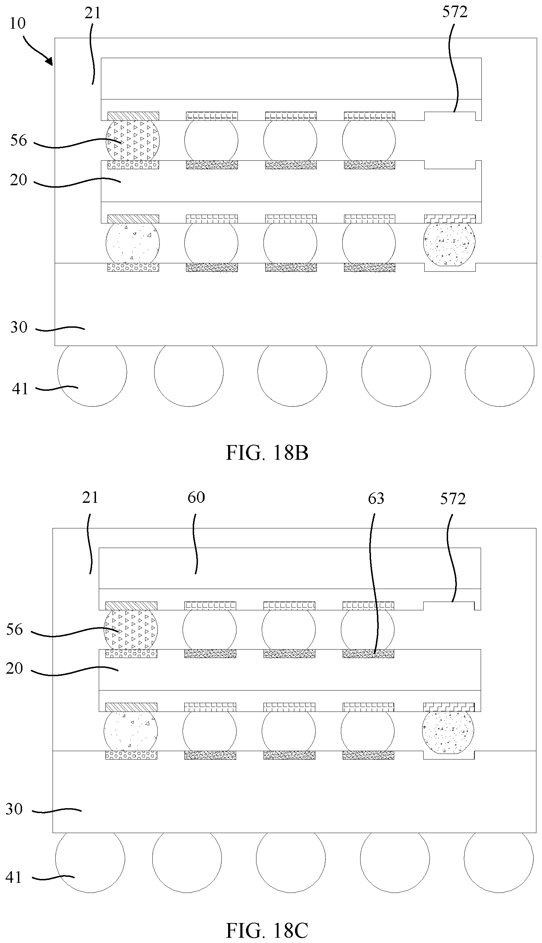

FIG. 18B is a schematic diagram showing that no component is disposed between a second redundant pad position and a first chip of an electronic device according to an embodiment of this application;
FIG. 18C is a schematic diagram showing that no component is disposed between a second redundant pad position and a first chip of an electronic device according to an embodiment of this application; and

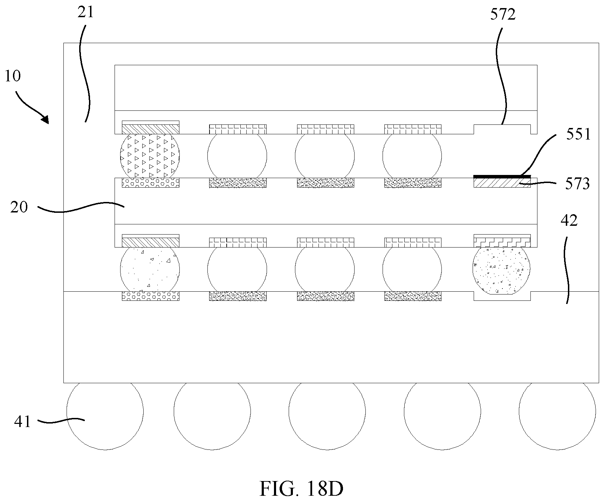

FIG. 18D is a schematic diagram showing that a third pad of an electronic device is disposed in a suspended manner according to an embodiment of this application.

Description of reference signs:
100-mobile phone; 10-circuit board assembly; 20-first chip; 21-epoxy molding compound; 30-first bottom plate; 31-bottom plate pad; 32-first bottom plate pad; 33, 42-package substrate; 40-circuit board; 41-solder ball; 50, 73-functional solder ball; 51-first surface; 52-functional pad; 53-redundant pad position; 54-first redundant pad position; 55, 551-solder mask layer; 56, 74-redundant solder ball; 57-first redundant pad; 571-third redundant pad; 572-third redundant pad position; 573-fourth pad; 60-second chip; 61-second functional solder ball; 62-second functional pad; 63-third pad; 64-second redundant pad position; 71-chip; 72-printed circuit board PCB; 76-back protective film; 81-display; 82-rear cover; 83-middle frame; 85-battery; 86-sound-producing component; 87-metal middle plate; 88-top frame; 89-bottom frame; 90-left frame; 91-right frame; 92-extreme low dielectric constant material layer; 93-metal layer; 94-original pad; 95-passivation layer; 96-first polyimide layer; 97-second polyimide layer; 98-rewiring metal; 99-rewiring layer; 101-bare chip; and 102-UBM.

### DESCRIPTION OF EMBODIMENTS

Terms used in implementations of this application are merely used to explain specific embodiments of this application, but are not intended to limit this application. The following describes implementations of embodiments of this application in detail with reference to accompanying drawings.

An embodiment of this application provides an electronic device. The electronic device includes but is not limited to a mobile or fixed terminal, for example, a mobile phone, a tablet computer, a notebook computer, an ultra-mobile personal computer (ultra-mobile personal computer, UMPC), a handheld computer, a walkie-talkie, a netbook, a POS terminal, a personal digital assistant (personal digital assistant, PDA), an event data recorder, a wearable device, or a virtual reality device.

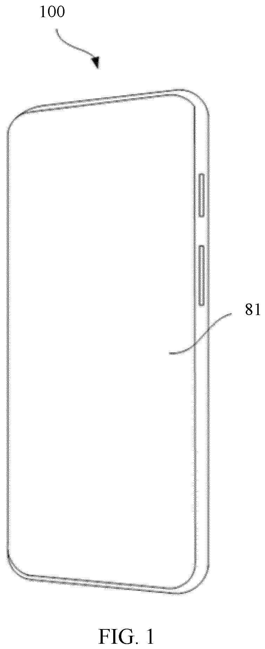

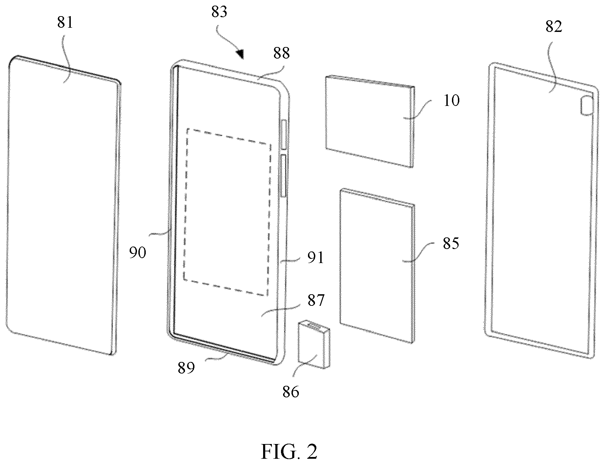

In this embodiment of this application, an example in which a mobile phone 100 is the foregoing electronic device is used for description. FIG. 1 and FIG. 2 respectively show an overall structure and a split structure of the mobile phone 100. As shown in FIG. 2, the mobile phone 100 may include a display 81 and a rear cover 82. A middle frame 83, a circuit board assembly 10, a battery 85, and a sound-producing component 86 may be disposed between the display 81 and the rear cover 82. The circuit board assembly 10, the battery 85, and the sound-producing component 86 may be disposed on the middle frame 83. For example, the circuit board assembly 10, the battery 85, and the sound-producing component 86 are disposed on a surface of the middle frame 83 facing the rear cover 82. Alternatively, the circuit board assembly 10, the battery 85, and the sound-producing component 86 may be disposed on a surface of the middle frame 83 facing the display 81.

In this embodiment of this application, when the battery 85 is disposed on the middle frame 83, for example, a battery compartment may be disposed on the surface of the middle frame 83 facing the rear cover 82, and the battery 85 is mounted in the battery compartment (as shown by a dashed-line box in FIG. 2) on the middle frame 83. In this embodiment of this application, the battery 85 may be connected to a charging management module and the circuit board assembly 10 through a power management module. The power management module receives input of the battery 85 and/or input of the charging management module, and supplies power to a processor, an internal memory, an external memory, the display 81, a camera, a communications module, and the like. The power management module may be further configured to monitor parameters such as a battery capacity, a battery cycle count, and a battery health status (electric leakage or impedance). In some other embodiments, the power management module may be alternatively disposed in a processor of the circuit board assembly 10. In some other embodiments, the power management module and the charging management module may be alternatively disposed in a same device.

To implement a loudspeaker function of the mobile phone 100, as shown in FIG. 2, the mobile phone 100 may further include the sound-producing component 86. The sound-producing component 86 may convert an audio electrical signal into a sound signal, and the mobile phone 100 may play music or implement hands-free calling via the sound-producing component 86. The sound-producing component 86 may be disposed on the surface of the middle frame 83 facing the rear cover 82. In this embodiment of this application, a microphone (not shown), namely, a mike, is further disposed in the mobile phone 100. The microphone is configured to convert a sound signal into an electrical signal. When making a call or sending voice information, the mouth of a user may get close to the microphone to make a sound, to input the sound signal to the microphone.

In this embodiment of this application, the display 81 may be an organic light-emitting diode (Organic Light-Emitting Diode, OLED) display, or may be a liquid crystal display (Liquid Crystal Display, LCD). It should be understood that the display 81 may include a display component and a touch component. The display component is configured to output display content to the user, and the touch component is configured to receive a touch event entered by the user on the display 81.

In this embodiment of this application, the rear cover 82 may be a metal cover, a glass cover, a plastic cover, or a ceramic cover. A material of the rear cover 82 is not limited in this embodiment of this application.

In this embodiment of this application, as shown in FIG. 2, the middle frame 83 may include a metal middle plate 87 and a frame, and the frame is disposed around the periphery of the metal middle plate 87. For example, the frame may include a top frame 88 and a bottom frame 89 that are disposed opposite to each other, and a left frame 90 and a right frame 91 that are located between the top frame 88 and the bottom frame 89 and that are disposed opposite to each other. A manner of connection between each of the frames and the metal middle plate 87 includes but is not limited to soldering, clamping, and integrated injection molding.

A material of the metal middle plate 87 may be aluminum or aluminum alloy, or a material of the metal middle plate 87 may be stainless steel. It should be noted that the material of the metal middle plate 87 includes but is not limited to the foregoing materials.

The frame (including the top frame 88, the bottom frame 89, the left frame 90, and the right frame 91) may be a metal frame, a glass frame, a plastic frame, or a ceramic frame.

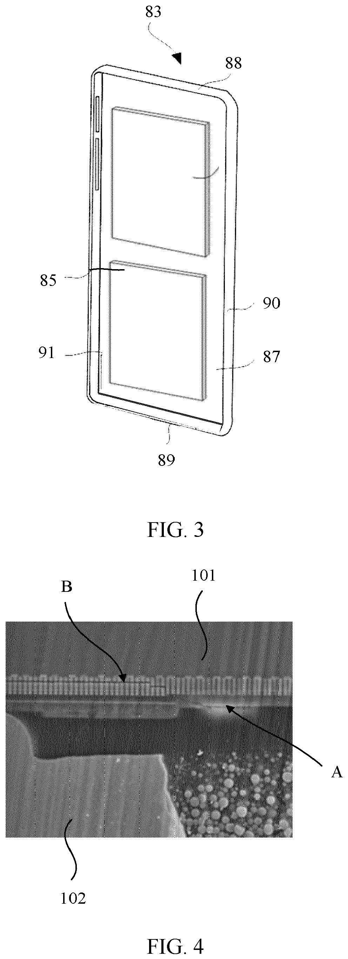

To more clearly show a structure in which the circuit board assembly 10 is mounted on the middle frame 83, as shown in FIG. 3, the circuit board assembly 10 and the battery 85 are sequentially disposed on the metal middle plate 87. Certainly, FIG. 3 is described by using a case in which the circuit board assembly 10 is located above the battery 85 as an example, and the circuit board assembly 10 may be alternatively located below, on the left side, on the right side, or the like of the battery 85.

It should be noted that, in some other examples, the mobile phone 100 may include a display 81 and a rear case. The rear case may be an integrated (Unibody) rear case that is formed by the rear cover 82 and the frame (namely, the frame including the top frame 88, the bottom frame 89, the left frame 90, and the right frame 91) in FIG. 2. The circuit board assembly 10 and the battery 85 are located in a cavity enclosed by the display 81 and the rear case.

It may be understood that the structure illustrated in this embodiment of this application does not constitute a specific limitation on the mobile phone 100. In other embodiments of this application, the mobile phone 100 may include more or fewer components than those shown in the figure, or combine some components, or split some components, or have a different component arrangement. For example, the mobile phone 100 may further include components such as the camera (for example, a front-facing camera and a rear-facing camera) and a flash.

In this application, the circuit board assembly may include a circuit board. According to a structure, the circuit board may be classified into a rigid printed circuit board (Printed Circuit Board, PCB), a flexible printed circuit board (Flexible Printed Circuit board, FPC), and a rigid flex printed circuit board. The circuit board in this application may be any one of the foregoing circuit boards.

It may be understood that the circuit board assembly of the mobile phone 100 may include a plurality of electronic components. In this application, a connection between one of the electronic components and the circuit board is used as an example for description. If the circuit board is connected to a plurality of other electronic components, the other electronic components may also be connected to the circuit board in a same manner, and details are not described herein again.

The electronic component is a component obtained by performing a packaging process on a cut wafer (which may also be referred to as a bare chip). In wafer level chip scale package (Wafer Level Chip Scale Package, WLCSP), a wafer is used as a processing object. A chip is directly packaged, aged, and tested on the wafer. The packaged wafer is cut, to obtain a single electronic component, which can be directly mounted on a substrate or a printed circuit board. Depending on whether a pad is redistributed or not, the wafer level chip scale package may be classified into a direct bump type and a redistribution type. For the direct bump type, a polyimide layer is directly deposited on the bare chip. The polyimide layer has a window corresponding to an original pad position on the bare chip. An under bump metallization (Under Bump Metallization, UBM) layer is disposed at the window and is electrically connected to an original pad, and then a solder bump is formed above the under bump metallization layer. Different from this, the redistribution type uses a thin film redistribution technique, so that an under bump metallization layer (a pad for bump metal connection) may be distributed on the entire surface of the electronic component, and is not limited to the periphery of the narrow bare chip. In flip chip chip scale package (Flip Chip Chip Scale Package, FCCSP), the bare chip is directly, via a solder ball, connected to a substrate for packaging. Because the chip is upside down on the substrate, and a placement direction of the chip is opposite to that of a conventional packaged chip, this technology is referred to as a flip chip packaging technology. In the flip chip package, a pad on the chip is directly connected to a pad on the substrate via a solder ball. Compared with lead interconnection and the like, this connection has features of a shortened signal transmission path and a small interconnection inductance.

In the conventional technology, if a circuit board or a substrate to which a bare chip is soldered is under stress, the stress is easily transferred to the side of the bare chip via a solder ball, and a metal layer and an extreme low dielectric constant material on the side of the bare chip are fractured as shown in FIG. 4. Consequently, the entire device fails. In FIG. 4, a letter "A" indicates a fracture of a PI (Polyimide, polyimide)/PBO (Polybenzoxazole, polybenzoxazole) layer, and a letter "B" indicates a fracture of the metal layer and the extreme low dielectric constant material (Extreme Low-K, ELK) layer. However, in this application, the foregoing failure case can be avoided by cutting off a propagation path of the stress.

The following uses the foregoing structure of the mobile phone 100 as an example to separately describe the structure of the mobile phone 100 in scenario 1, scenario 2, and scenario 3.

### Scenario 1

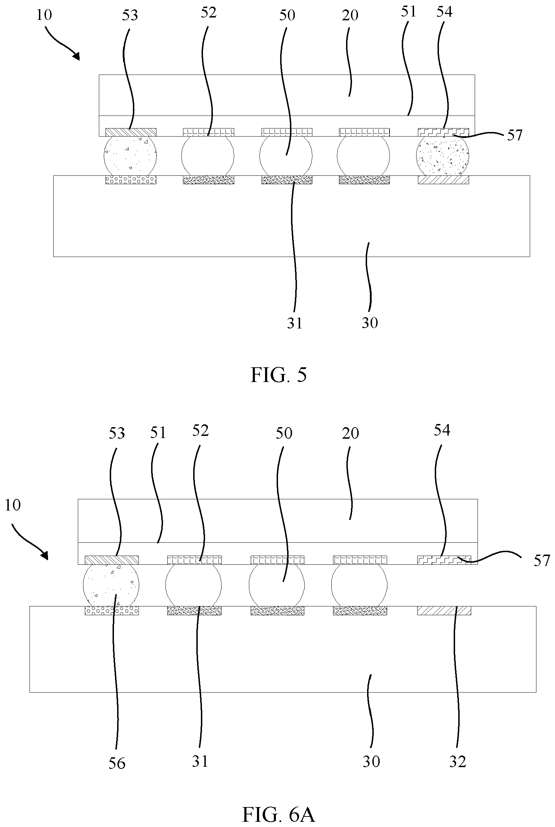

In this application, as shown in FIG. 5, the circuit board assembly 10 includes a first chip 20 and a first bottom plate 30. The first chip 20 is a bare chip, and the first bottom plate 30 may be a circuit board, for example, a printed circuit board PCB. The printed circuit board PCB may include a single-sided board, a double-sided board, a multi-sided board, and the like. In this scenario, an example in which the first bottom plate 30 is a single-sided printed circuit board PCB is used for description, and an active surface of the printed circuit board PCB is disposed toward the first chip 20. The circuit board assembly 10 further includes a plurality of functional solder balls 50. An array of functional pads 52 is disposed on a first surface 51 of the first chip 20, a plurality of bottom plate pads 31 are disposed on the first bottom plate 30, and the functional pads 52 are electrically connected to the corresponding bottom plate pads 31 via the functional solder balls 50. The first chip 20 is further provided with a redundant pad position 53, and the redundant pad position 53 is configured to dispose a redundant pad. The structural diagram shown in FIG. 5 is actually a side sectional view of the circuit board assembly. It may be understood that solder joints formed by a plurality of solder balls and pads on a real circuit board assembly are actually arrayed on a first substrate or arranged according to other rules. Structures of all circuit board assemblies in this application are similar to the structure of the circuit board assembly shown in FIG. 5. A top view of the circuit board assembly is not described in detail herein again. In this application, definitions of a solder ball and a pad are broad meanings. For example, when the first chip 20 is connected to a substrate, the solder ball indicates a bump connected to the first chip 20, and the pad indicates an under bump metallization (Under Bump Metallization, UBM) layer. If the first chip 20 is connected to a printed circuit board PCB, the solder ball (Solder Ball) indicates a soldering material ball, and the pad indicates an under solder ball metallization layer (Under Bump Metallization, UBM).

Pads may be classified into functional pads and non-functional/redundant pads, and solder balls may be classified into functional solder balls and non-functional/redundant solder balls. Cooperation between the functional pad and the functional solder ball is a necessary condition for ensuring a normal electrical function of a chip. For example, the functional pad is electrically connected to a corresponding bottom plate pad via the functional solder ball, to implement an electrical connection and a mechanical connection between the chip and the first bottom plate. This ensures that the chip is correctly assembled/packaged on the first bottom plate. The redundant pad and the redundant solder ball cooperate with each other, and may be used as a backup pad of the functional pad and a backup solder ball of the functional solder ball, or may be used as stress buffer components of the functional solder ball and the functional pad. For example, the redundant pads and the redundant solder balls may also have an electrical function, and have the same electrical function as some functional pads and functional solder balls. However, when the redundant pads and the redundant solder balls are not connected to a substrate/printed circuit board, a function exception of the circuit board assembly is not caused. When one or some functional pads or functional solder balls are faulty, the redundant pads or redundant solder balls as backups may be used as substitutes to replace the faulty functional pads or functional solder balls for implementing the electrical connection. For another example, stress exerted on functional pads and functional solder balls at some positions (for example, corners) is greater than stress exerted on other internal functional pads and functional solder balls, and consequently, fatigue cracks are prone to generate to cause a device failure. To avoid this case, a plurality of redundant pads and redundant solder balls only for mechanical connection rather than electrical connection are disposed on the peripheries of the functional pads and the functional solder balls at these corners. This can relieve stress and strain of the functional pads and the functional solder balls that are prone to generate fatigue cracks, to prolong a service life of the device. Specifically, the redundant pads and the redundant solder balls may be disposed on the outer sides of the functional pads and the functional solder balls that are prone to generate fatigue cracks, or disposed on the sides of functional pads and functional solder balls that need to perform redundancy backup. During actual application, these specific positions may be set as required.

Therefore, the redundant pad positions 53 for disposing the redundant pads may be disposed on the first chip 20. To prevent stress exerted on the first bottom plate 30 from being concentrated on some portions of the first chip 20, a part or all of the redundant pad positions 53 may be disconnected from the first bottom plate 30 (this disconnection case is not shown in FIG. 5). Certainly, among the redundant pad positions 53, only a redundant pad position 53 in a failure-prone area on the chip is disconnected from the first bottom plate 30. In this way, the redundant pad positions 53 include a first redundant pad position 54 that is disconnected from the first bottom plate 30, and the first redundant pad position 54 may be located in the failure-prone area on the first chip 20, to implement stress isolation between the first bottom plate 30 and the first redundant pad position 54. Therefore, the first redundant pad position 54 and a corresponding position of the first bottom plate 30 are in a stress isolation state. When the first bottom plate 30 is under stress, the stress is not concentrated on the first redundant pad position 54. This can improve reliability of the circuit board assembly 10. In addition, when the circuit board assembly 10 is faulty, compared with that in a solution of filling an underfill in the conventional technology, the first chip 20 is easy to detach, and therefore maintenance costs are relatively low. In addition, a time period in which the underfill cures is saved, and a process of preheating a chip to improve a filling effect does not need to be performed. Therefore, the production efficiency can also be improved. In addition, in the conventional technology, sometimes, to alleviate impact of thermal stress on a solder joint, it is avoided as far as possible that a large-sized component is disposed on the back side of the first bottom plate. Consequently, more limitations are imposed on layout of components on the first bottom plate. However, antistress performance of the chip in the circuit board assembly in embodiments of this application is improved, so that sizes of the components on the first bottom plate are not limited, and the limitations on the layout of the components on the first bottom plate are also reduced.

The failure-prone area on the first chip 20 may be determined in two manners: a reliability test and a computer simulation test. For the reliability test, a temperature cycle test and/or a temperature shock test may be performed on a packaged circuit board assembly. After the test is completed, failure analysis is performed on a failure area, to determine a failure-prone area on a chip. For the computer simulation test, stress and strain exerted on pads and solder balls corresponding to areas on the first chip 20 in a temperature shock or temperature cycle process may be simulated by using a computer. When stress and strain values corresponding to some pads or solder balls are abnormal, for example, exceed an empirical value, it is considered that areas that are on the first chip 20 and that correspond to the pads or the solder balls whose stress and strain values are abnormal are the failure-prone areas. Certainly, a method for determining a failure-prone area on the first chip 20 herein includes but is not limited to the foregoing two methods, and may also include another common method in the semiconductor packaging field.

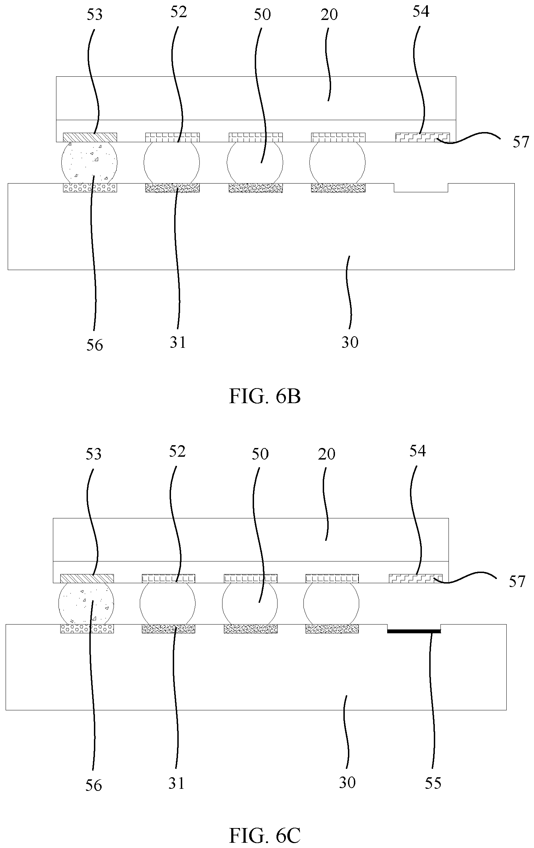

In this embodiment of this application, a first redundant pad 57 is also disposed on the first surface 51. The first redundant pad 57 is connected to the first redundant pad position 54, and one end of the first redundant pad 57 away from the first redundant pad position 54 is disconnected from the first bottom plate 30, for example, the end may be disposed in a suspended manner (or the end may be disposed in a non-suspended manner, and is in contact with, but is not connected to, a component on the side of the first bottom plate, and in this way, stress is not transferred). In this way, there is space between the first redundant pad 57 and the first bottom plate 30 or between the first redundant pad 57 and another component on the first bottom plate 30, and there is no other component in the space. Therefore, the first redundant pad position 54 can be disconnected from the first bottom plate 30, to implement stress isolation between the two. For example, the case in which the first redundant pad 57 is disposed in a suspended manner may be as shown in FIG. 6A. Only the first redundant pad 57 and a first bottom plate pad 32 are disposed between the first redundant pad position 54 and a corresponding part of the first bottom plate 30. The bottom plate pads 31 are disposed on an active surface of the first bottom plate 30, for example, a surface opposite to the first chip 20. In this case, one end of the first bottom plate pad 32 away from the first bottom plate 30 is also disposed in a suspended manner, that is, a corresponding redundant solder ball 56 on the side of the first chip 20 is directly removed. For example, the case in which the first redundant pad 57 is disposed in a suspended manner may alternatively be as shown in FIG. 6B. Only the first redundant pad 57 is disposed between the first redundant pad position 54 and a corresponding part of the first bottom plate 30. For example, the case in which the first redundant pad 57 is disposed in a suspended manner may alternatively be as shown in FIG. 6C. Only the first redundant pad 57 and a solder mask layer 55 are disposed between the first redundant pad position 54 and a corresponding part of the first bottom plate 30. The bottom plate pads 31 are disposed on an active surface of the first bottom plate 30, for example, a surface opposite to the first chip 20. For example, the case in which the first redundant pad 57 is disposed in a suspended manner may alternatively be as shown in FIG. 6D. Only the first redundant pad 57, a solder mask layer 55, and a first bottom plate pad 32 are disposed between the first redundant pad position 54 and a corresponding part of the first bottom plate 30. The cases shown in FIG. 6B and FIG. 6C are equivalent to that a corresponding bottom plate pad on the side of the first bottom plate 30 is directly removed, and the corresponding position is covered with or without the solder mask layer 55.

In a possible implementation, the circuit board assembly 10 further includes the redundant solder ball 56, and the first redundant pad 57 is also disposed on the first surface 51. The first redundant pad 57 is connected to the first redundant pad position 54. The redundant solder ball 56 is connected to the first redundant pad 57. One end of the redundant solder ball 56 away from the first redundant pad 57 is disposed in a suspended manner (or the end may be disposed in a non-suspended manner, and is in contact with, but is not connected to, a component on the side of the first bottom plate, and in this way, stress is not transferred). One end of the redundant solder ball 56 away from the first redundant pad 57 is disposed in a suspended manner. In this way, there is space between the redundant solder ball 56 and the first bottom plate 30 or between the redundant solder ball 56 and another component on the first bottom plate 30, and there is no other component in the space. Therefore, the first redundant pad position 54 can be disconnected from the first bottom plate 30, to implement stress isolation between the two. For example, the foregoing implementation may be as shown in FIG. 7A. Only the first redundant pad 57 and the redundant solder ball 56 are disposed between the first redundant pad position 54 and a corresponding part of the first bottom plate 30. The redundant solder ball 56 is connected to a surface of the first redundant pad 57 away from the first chip 20. For this manner, refer to FIG. 7A' which is a real picture of the circuit board assembly. This picture shows a technical solution in which two solder balls on the left side are functional solder balls, and two solder balls on the right side are solder balls for a redundancy function. First bottom plate pads under the two solder balls on the right side are removed, to disconnect first redundant pads from the first bottom plate 30. A back protective film 76 is disposed on an upper surface of the first chip 20, to implement a function of protecting the first chip 20. For example, the foregoing implementation may alternatively be as shown in FIG. 7B. Only the first redundant pad 57, the redundant solder ball 56, and the solder mask layer 55 are disposed between the first redundant pad position 54 and a corresponding part of the first bottom plate 30. The redundant solder ball 56 is connected to a surface of the first redundant pad 57 away from the first chip 20. The solder mask layer 55 is connected to an active surface of the first bottom plate 30. The cases shown in FIG. 7A and FIG. 7B are equivalent to that a corresponding bottom plate pad on the side of the first bottom plate 30 is directly removed, and the corresponding position is covered with or without the solder mask layer 55.

In a possible implementation, as shown in FIG. 7C, the circuit board assembly 10 further includes the redundant solder ball 56 and the solder mask layer 55, and the first redundant pad 57 is also disposed on the first surface 51. The bottom plate pads 31 include the first bottom plate pad 32 corresponding to the first redundant pad 57, the first redundant pad 57 is located at the first redundant pad position 54, the redundant solder ball 56 is connected to the first redundant pad 57, the first bottom plate pad 32 is connected to the first bottom plate 30, and the solder mask layer 55 is connected to the first bottom plate pad 32. The redundant solder ball 56 is in contact with the solder mask layer 55, or the redundant solder ball 56 is in non-contact with the solder mask layer 55 (not shown in the figure). The solder mask layer 55 is disposed between the redundant solder ball 56 and the first bottom plate pad 32. Therefore, in a soldering process, the redundant solder ball 56 cannot be connected to the first bottom plate pad 32. In this way, the redundant solder ball 56 is disconnected from the first bottom plate pad 32. Although the redundant solder ball 56 and the first bottom plate pad 32 may be in contact with each other, stress cannot be transferred between the two, and therefore, the stress on the first bottom plate 30 cannot be concentrated on the first redundant pad position 54.

In a possible implementation, as shown in FIG. 8A, the bottom plate pads 31 include the first bottom plate pad 32 corresponding to the first redundant pad position 54, one end of the first bottom plate pad 32 away from the first bottom plate 30 is disposed in a suspended manner (or the end may be disposed in a non-suspended manner, and is in contact with, but is not connected to, a component on the side of the first chip, and in this way, stress is not transferred). Only the first bottom plate pad 32 is disposed between the first redundant pad position 54 and a corresponding part of the first bottom plate 30, that is, a corresponding first redundant pad and a corresponding redundant solder ball on the side of the first chip 20 are directly removed.

In a possible implementation, as shown in FIG. 8B, no connection component is disposed between the first redundant pad position 54 and a corresponding position on the first bottom plate 30. In this way, a best disconnection effect can be achieved between the first redundant pad position 54 and the first bottom plate 30.

In a possible implementation, as shown in FIG. 8C, the solder mask layer is disposed on the first bottom plate 30. Only the solder mask layer 55 is disposed between the first redundant pad position 54 and a corresponding part of the first bottom plate 30, this is, a corresponding first redundant pad and a corresponding redundant solder ball on the side of the first chip 20 are directly removed, and a corresponding bottom plate pad on the side of the first bottom plate 30 is removed.

In a possible implementation, as shown in FIG. 8D, the bottom plate pads 31 include the first bottom plate pad 32 corresponding to the first redundant pad position 54, and one end of the first bottom plate pad 32 away from the first bottom plate 30 is covered with the solder mask layer 55. Only the first bottom plate pad 32 and the solder mask layer 55 are disposed between the first redundant pad position 54 and a corresponding part of the first bottom plate 30, that is, a corresponding first redundant pad and a corresponding redundant solder ball on the side of the first chip 20 are directly removed.

It may be understood that, in the solution in which the first bottom plate pad 32 of the first bottom plate 30 is removed to isolate stress, because there is no first bottom plate pad 32, a solder ball is difficult to short-circuit a surrounding solder joint in a component soldering collapse process. However, for the solution in which the first redundant pad 57 and the solder ball are removed, a design of the first bottom plate 30, for example, a printed circuit board PCB, is not changed.

In this scenario, the first bottom plate 30 is a printed circuit board PCB. In a possible implementation, the first chip 20 may be packaged by using the wafer level chip scale package. The functional pad 52 and the redundant pad are disposed on the first chip 20 by using a rewiring layer, and as shown in FIG. 9, an example in which the first redundant pad 57 is packaged is used for description. The rewiring layer 99 includes two dielectric layers (such as a first polyimide layer 96 and a second polyimide layer 97) and a rewiring metal 98 that are disposed on the first chip 20. The rewiring metal 98 is sandwiched between the two dielectric layers, and the rewiring metal 98 is configured to connect an original pad 94 that is disposed on the first chip 20 to the first redundant pad 57. By disposing the rewiring layer 99, chips at the four edges of a pad may be converted into the first chips 20 facing a solder ball array. Finally, the pad is rearranged. The original pad 94 is disposed on a surface of the first chip 20, a passivation layer 95 is also disposed between the first chip 20 and the rewiring layer 99, and a window is disposed on the passivation layer 95, so that the original pad 94 is exposed. The first chip 20 includes an extreme low dielectric constant material layer 92 and a metal layer 93 that are disposed in an overlapping manner. In the figure, an example in which the extreme low dielectric constant material layer 92 and the metal layer 93 overlap with each other is used for description. In practice, a plurality of the layers may be disposed, and the extreme low dielectric constant material layers 92 and the metal layers 93 overlap with each other alternately. In addition, when the first bottom plate is a printed circuit board PCB, no substrate is disposed on the first chip for stress isolation from the first bottom plate. Therefore, it is more applicable to components that use fan-in (Fan-in) WLCSP and fan-out (Fan-out) WLCSP and that have a higher failure risk of a metal layer on the side of the chip.

To verify effects of the solutions in this scenario, the following uses a computer to simulate a temperature shock plastic strain condition in a temperature shock and temperature cycle process. Simulation objects are all functional solder joints (the functional pad 52 and the functional solder balls 50) and all redundant pad positions 53 on the first chip 20 of the circuit board assembly 10 that is packaged based on WLCSP, a spacing between the solder balls is 0.4 mm, and a quantity of solder ball arrays is 11X12. In addition, the circuit board assembly 10 has the first redundant pad 57, the redundant solder ball 56, the solder mask layer 55, and the first bottom plate pad 32 between the first redundant pad position 54 and the first bottom plate 30 at the same time. In addition, to compare with that in the conventional technology, a circuit board assembly in the conventional technology shown in FIG. 10 is also simulated. A chip 71 in the conventional technology is separately connected to functional pads on a printed circuit board PCB 72 via functional solder balls 73, and the chip 71 in the conventional technology is connected to redundant pads on the printed circuit board PCB 72 by using redundant solder balls 74. As shown in FIG. 11, there is a first redundant solder ball (represented by a letter A12) whose stress and strain exceed empirical values on the redundant pad, the value of strain has reached a maximum value 1.582e-2 (A12), and thermal shock plastic strain corresponding to a solder ball (represented by a letter A11) that is on the left side in an X-axis direction and that is adjacent to the first redundant solder ball is 1.253e-02 (A11). In this case, a metal layer fracture has occurred at a position that is on the chip and that corresponds to the first redundant solder ball A11, and consequently, the entire circuit board assembly fails. Temperature shock plastic strain corresponding to a solder ball (represented by a letter B12) that is on the lower side in a Y-axis direction and that is adjacent to the first redundant solder ball is 1.302e-02 (B12). As shown in FIG. 12, in this embodiment, a first chip 20 is separately connected to functional pads on a first bottom plate 30 via functional solder balls 50, and first bottom plate pads corresponding to two first redundant pads 57 are removed. As shown in FIG. 13, stress and strain at each position of the first chip 20 do not exceed empirical values. Therefore, no metal layer fracture occurs on the first chip 20. Temperature shock plastic strain corresponding to a solder joint (represented by a letter A12) that is on an uppermost side in an X-axis direction and an uppermost side in a Y-axis direction is 0.324e-02 (A12), temperature shock plastic strain corresponding to a solder joint (represented by a letter A11) on the left side of the foregoing solder joint (represented by the letter A12) is also 0.324e-02 (A11), and temperature shock plastic strain corresponding to a solder joint (represented by a letter B12) on a lower side the foregoing solder joint (represented by the letter A12) in the Y-axis direction is 1.378e-02 (B12). In the circuit board assembly 10 packaged based on WLCSP, for a first redundant solder ball having the maximum plastic strain, the maximum temperature shock plastic strain decreases by 13% (from 1.582e-2 to 1.378e-2), and the temperature shock plastic strain of the solder joint A11 on which a metal layer is fractured and fails decreases by 74% (from 1.253e-2 to 0.324e-2). In the actual temperature shock test, the service life is increased from fewer than 200 cycles to more than 500 cycles. It can be seen from the above that, the reliability of the circuit board assembly adopting the structure in this embodiment is improved.

### Scenario 2

In this embodiment of this application, refer to FIG. 14. The circuit board assembly 10 includes a first chip 20, a first bottom plate 30, and a plurality of functional solder balls 50. An array of functional pads 52 is disposed on a first surface 51 of the first chip 20, and a plurality of bottom plate pads 31 are disposed on the first bottom plate 30. The functional pads 52 are electrically connected to the corresponding bottom plate pads 31 via the functional solder balls 50. The first chip 20 is further provided with a redundant pad position 53. The redundant pad position 53 is configured to dispose a redundant pad, and the redundant pad position 53 includes a first redundant pad position 54 that is disconnected from the first bottom plate 30, to implement stress isolation between the first bottom plate 30 and the first redundant pad position 54. When the first bottom plate 30 is a package substrate 33, the first chip 20 may be packaged in a flip chip chip scale package manner. In addition, an epoxy molding compound 21 (Epoxy Molding Compound, EMC) further needs to cover the upper part of the first chip 20. It may be understood that, in a WLCSP-based chip package, no substrate and epoxy molding compound are used for protection, and a mismatch between a coefficient of thermal expansion of a chip and a coefficient of thermal expansion of a printed circuit board PCB is relatively large. As a result, during board-level application of the WLCSP, there is a relatively large challenge to temperature shock and drop reliability, especially to an ELK fracture failure mode with relatively low mechanical strength. However, in an FCCSP-based chip package, a substrate is disposed below a chip, and an epoxy molding compound covers the chip. Therefore, during application of FCCSP at a package level, there is a relatively small challenge to temperature shock and drop reliability.

The circuit board assembly 10 may further include a circuit board 40, for example, a first printed circuit board. The package substrate 33 at the bottom of the packaged first chip 20 may be fixed on the circuit board 40 via a solder ball 41. Because the first redundant pad position 54 is disconnected from the package substrate 33, the first redundant pad position 54 and a corresponding position of the package substrate 33 are in a stress isolation state. The first redundant pad position 54 is disposed in an area in which stress is easily concentrated on the first chip 20, for example, at a failure-prone position on the first chip 20. In this way, when the circuit board 40 is under stress, the stress is transferred to the package substrate 33 through the solder ball, but is not concentrated on the first redundant pad position 54. This can improve reliability of the first chip 20. In addition, when the circuit board assembly 10 is faulty, compared with that in a solution of filling an underfill in the conventional technology, the first chip 20 is easy to detach, and therefore maintenance costs are relatively low. A specific manner in which the first redundant pad position 54 is disconnected from the first bottom plate 30 is similar to that in scenario 1, and details are not described herein again.

### Scenario 3

In this embodiment of this application, refer to FIG. 15. The circuit board assembly 10 includes a first chip 20, a first bottom plate 30, and a plurality of functional solder balls 50. An array of functional pads 52 is disposed on a first surface 51 of the first chip 20, and a plurality of bottom plate pads 31 are disposed on the first bottom plate 30. The functional pads 52 are electrically connected to the corresponding bottom plate pads 31 via the functional solder balls 50. The first chip 20 is further provided with a redundant pad position 53. The redundant pad position 53 is configured to dispose a redundant pad, and the redundant pad position 53 includes a first redundant pad position 54 that is disconnected from the first bottom plate 30, to implement stress isolation between the first bottom plate 30 and the first redundant pad position 54.

The circuit board assembly 10 further includes a second chip 60 and a plurality of second functional solder balls 61. An array of second functional pads 62 is disposed on the second chip 60. A plurality of third pads 63 are disposed on a second surface of the first chip 20 away from the first bottom plate 30. The second functional pads 62 are electrically connected to the corresponding third pads 63 via the second functional solder balls 61. The second chip 60 is provided with a second redundant pad position 64. The second redundant pad position 64 is configured to dispose a redundant pad, and the second redundant pad position 64 includes a third redundant pad position 572. The third redundant pad position 572 is disconnected from the first chip 20, to implement stress isolation between the first chip 20 and the third redundant pad position 572. In addition, the first bottom plate 30 may be a package substrate. In this way, an FCCSP package may be performed on the first chip 20 and the second chip 60. The second chip 60 is further provided with an epoxy molding compound 21. Furthermore, when the first bottom plate 30 is the package substrate, a solder ball 41 may be further disposed on the back side of the first bottom plate 30. For example, a circuit board (not shown in the figure) may be connected by using the solder ball 41.

The second chip 60 is disposed above the first chip 20, and the stress isolation between the first chip 20 and the third redundant pad position 572 is implemented. In this way, the third redundant pad position 572 and a corresponding position of the first chip 20 are in a stress isolation state. The third redundant pad position 572 is disposed in an area in which stress is easily concentrated on the second chip 60, for example, at a failure-prone position on the second chip 60. In this way, when the first chip 20 is under stress, the stress is not concentrated on the third redundant pad position 572. This can improve reliability of the circuit board assembly 10. In addition, when the circuit board assembly 10 is faulty, compared with that in a solution of filling an underfill in the conventional technology, the second chip 60 is connected to the first chip via the solder balls, and replacement can be completed by using only a conventional means, so that maintenance costs are relatively low.

A specific manner in which the second redundant pad position 64 is disconnected from the first chip 20 is similar to that in scenario 1.

In a possible implementation, a third redundant pad is further disposed on the second chip 60, and the third redundant pad is connected to the third redundant pad position 572. One end of the third redundant pad away from the third redundant pad position 572 is disposed in a suspended manner (or the end may be disposed in a non-suspended manner, and is in contact with, but is not connected to, a component on the side of the first chip, and in this way, stress is not transferred). In this way, there is space between the third redundant pad and the first chip 20 or between the third redundant pad and another component on the first chip 20, and there is no other component in the space. Therefore, the third redundant pad position can be disconnected from the first chip 20, to implement stress isolation between the two. For example, the case in which the third redundant pad 571 is disposed in a suspended manner may be as shown in FIG. 16A. Only the third redundant pad 571 and the third pad 63 are disposed between the third redundant pad position 572 and a corresponding part of the first chip 20. The third pad 63 is disposed on a surface of the first chip 20 opposite to the second chip 60. In this case, one end of the third pad 63 away from the first chip 20 is also disposed in a suspended manner, that is, a corresponding redundant solder ball 56 on the side of the second chip 60 is directly removed. For example, the case in which the third redundant pad 571 is disposed in a suspended manner may alternatively be as shown in FIG. 16B. Only the third redundant pad 571 is disposed between the third redundant pad position 572 and a corresponding part of the first chip 20. For example, the case in which the third redundant pad 571 is disposed in a suspended manner may alternatively be as shown in FIG. 16C. Only the third redundant pad 571 and a solder mask layer 551 are disposed between the third redundant pad position 572 and a corresponding part of the first chip 20. The third pad 63 is disposed on a surface of the first chip 20 opposite to the second chip 60. For example, the case in which the third redundant pad 571 is disposed in a suspended manner may alternatively be as shown in FIG. 16D. Only the third redundant pad 571, a solder mask layer 551, and a fourth pad 573 are disposed between the third redundant pad position 572 and a corresponding part of the first chip 20. The third pad 63 is disposed on a surface of the first chip 20 opposite to the second chip 60. The cases shown in the FIG. 16B and FIG. 16C are equivalent to that a corresponding third pad 63 on the side of the first chip 20 is directly removed, and the corresponding position is covered with or without the solder mask layer 551.

In a possible implementation, the circuit board assembly 10 further includes a redundant solder ball 56, and a third redundant pad 571 is further disposed on the second chip 60. The third redundant pad 571 is connected to the third redundant pad position 572. The redundant solder ball 56 is connected to the third redundant pad 571. One end of the redundant solder ball 56 away from the third redundant pad 571 is disposed in a suspended manner (or the end may be disposed in a non-suspended manner, and is in contact with, but is not connected to, a component on the side of the first chip, and in this way, stress is not transferred). One end of the redundant solder ball 56 away from the third redundant pad 571 is disposed in a suspended manner. In this way, there is space between the redundant solder ball 56 and the first chip 20 or between the redundant solder ball 56 and another component on the first chip 20, and there is no other component in the space. Therefore, the third redundant pad position 572 can be disconnected from the first chip 20, to implement stress isolation between the two. For example, the foregoing implementation may be as shown in FIG. 17A. Only the third redundant pad 571 and the redundant solder ball 56 are disposed between the third redundant pad position 572 and a corresponding part of the first chip 20. The redundant solder ball 56 is connected to a surface of the third redundant pad 571 close to the first chip 20. For example, the foregoing implementation may alternatively be as shown in FIG. 17B. Only the third redundant pad 571, the redundant solder ball 56, and a solder mask layer 551 are disposed between the third redundant pad position 572 and a corresponding part of the first chip 20. The redundant solder ball 56 is connected to the surface of the third redundant pad 571 close to the first chip 20, and the solder mask layer 551 is connected to a surface of the first chip 20 away from the first surface. The cases shown in the FIG. 17A and FIG. 17B are equivalent to that a corresponding third pad 63 on the side of the first chip 20 is directly removed, and the corresponding position is covered with or without the solder mask layer 551. For example, the foregoing implementation may alternatively be as shown in FIG. 17D. Only the third redundant pad 571 and the redundant solder ball 56 are disposed between the third redundant pad position 572 and a corresponding part of the first chip 20. The redundant solder ball 56 is connected to a surface of the third redundant pad 571 close to the first chip 20. A substrate is in a flattened state on a surface of the first chip 20 opposite to the second chip 60.

In a possible implementation, as shown in FIG. 17C, the circuit board assembly 10 further includes a redundant solder ball 56 and a solder mask layer 551, and a third redundant pad 571 is also disposed on the second chip 60. The third pad 63 includes a fourth pad 573 corresponding to the third redundant pad 571. The third redundant pad 571 is connected to the third redundant pad position 572, the redundant solder ball 56 is connected to the third redundant pad 571, the fourth pad 573 is connected to the first chip 20, the solder mask layer 551 is connected to the fourth pad 573, and the redundant solder ball 56 is in contact with the solder mask layer 551, or the redundant solder ball 56 is in non-contact with the solder mask layer 551 (not shown in the figure). The solder mask layer 551 is disposed between the redundant solder ball 56 and the fourth pad 573. Therefore, in a soldering process, the redundant solder ball 56 cannot be connected to the fourth pad 573 through soldering. In this way, the redundant solder ball 56 is disconnected from the fourth pad 573. Although the redundant solder ball 56 and the fourth pad 573 may be in contact with each other, stress cannot be transferred between the two, and therefore, the stress on the first chip 20 cannot be concentrated on the third redundant pad position 572.

In a possible implementation, as shown in FIG. 18A, the third pad 63 includes a fourth pad 573 corresponding to the third redundant pad position 572, and one end of the fourth pad 573 away from the second chip 60 is disposed in a suspended manner. Only the fourth pad 573 is disposed between the third redundant pad position 572 and a corresponding part of the first chip 20, that is, a corresponding third redundant pad and a corresponding redundant solder ball on the side of the second chip 60 are directly removed.

In a possible implementation, as shown in FIG. 18B, no connection component is disposed between the third redundant pad position 572 and a corresponding position on the first chip 20. In this way, a best disconnection effect can be achieved between the third redundant pad position 572 and the first chip 20.

In a possible implementation, as shown in FIG. 18C, no connection component is disposed between the third redundant pad position 572 and a corresponding position on the first chip 20. In this way, a best disconnection effect can be achieved between the third redundant pad position 572 and the first chip 20. A substrate is in a flattened state on a surface of the first chip 20 opposite to the third redundant pad position 572.

In a possible implementation, as shown in FIG. 18D, the third pad 63 includes a fourth pad 573 corresponding to the third redundant pad position 572, and a solder mask layer 551 is disposed at one end of the fourth pad 573 away from the second chip 60. Only the fourth pad 573, the solder mask layer 551, and the fourth pad 573 are disposed between the third redundant pad position 572 and a corresponding part of the first chip 20, that is, a corresponding third redundant pad and a corresponding redundant solder ball on the side of the second chip 60 are directly removed.

In this scenario, the first bottom plate may be a package substrate 42, and the assembled first chip 20 and second chip 60 may be fixed on the package substrate 42 via the solder balls. It may be understood that, in this case, the circuit board assembly 10 may further include a circuit board, for example, a first printed circuit board, and the package substrate 42 may be connected to the first printed circuit board via the solder balls 41.

In the descriptions of embodiments of this application, it should be noted that, unless otherwise clearly specified and limited, terms "mounted", "connected", and "connection" should be understood in a broad sense. For example, the terms may be used for a fixed connection, an indirect connection through an intermediate medium, an internal connection between two elements, or an interaction relationship between two elements. For persons of ordinary skill in the art, specific meanings of the foregoing terms in embodiments of this application may be understood according to a specific situation.

In the specification, claims, and accompanying drawings of embodiments of this application, the terms "first", "second", "third", "fourth", and the like (if any) are intended to distinguish between similar objects, but do not necessarily indicate a specific order or sequence.

Finally, it should be noted that the foregoing embodiments are merely intended for describing the technical solutions of embodiments of this application other than limiting embodiments of this application. Although embodiments of this application are described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of embodiments of this application.

## Claims

1. A circuit board assembly, applied to an electronic device, and comprising a first chip, a first bottom plate, and a plurality of functional solder balls, wherein an array of functional pads is disposed on a first surface of the first chip, a plurality of bottom plate pads are disposed on the first bottom plate, the functional pads are electrically connected to the corresponding bottom plate pads via the functional solder balls, the first chip is further provided with a redundant pad position, the redundant pad position is configured to dispose a redundant pad, the redundant pad position comprises a first redundant pad position, and the first redundant pad position is disconnected from the first bottom plate, to implement stress isolation between the first bottom plate and the first redundant pad position.

2. The circuit board assembly according to claim 1, wherein a first redundant pad is further disposed on the first surface, the first redundant pad is connected to the first redundant pad position, and one end of the first redundant pad away from the first redundant pad position is disposed in a suspended manner.

3. The circuit board assembly according to claim 1 or 2, wherein the bottom plate pads comprise a first bottom plate pad corresponding to the first redundant pad position, and one end of the first bottom plate pad away from the first bottom plate is disposed in a suspended manner.

4. The circuit board assembly according to claim 1, further comprising a redundant solder ball, wherein a first redundant pad is further disposed on the first surface, the first redundant pad is connected to the first redundant pad position, the redundant solder ball is connected to the first redundant pad, and one end of the redundant solder ball away from the first redundant pad is disconnected from the first bottom plate.

5. The circuit board assembly according to claim 2 or 4, wherein a solder mask layer is disposed at a position that is on the first bottom plate and opposite to the first redundant pad.

6. The circuit board assembly according to claim 1, further comprising a redundant solder ball and a solder mask layer, wherein a first redundant pad is further disposed on the first surface, the bottom plate pads comprise a first bottom plate pad corresponding to the first redundant pad, the first redundant pad is connected to the first redundant pad position, the redundant solder ball is connected to the first redundant pad, the first bottom plate pad is connected to the first bottom plate, the solder mask layer is connected to the first bottom plate pad, and the redundant solder ball is in contact with the solder mask layer, or the redundant solder ball is suspended.

7. The circuit board assembly according to any one of claims 1 to 6, wherein the first bottom plate is a printed circuit board or a package substrate.

8. The circuit board assembly according to claim 7, wherein when the first bottom plate is the printed circuit board, the functional pads and the redundant pad are disposed on the first chip by using a rewiring layer, the rewiring layer comprises two dielectric layers and a rewiring metal that are disposed on the first chip, the rewiring metal is sandwiched between the two dielectric layers, and the rewiring metal is configured to connect an original pad disposed on the first chip to the functional pads and the redundant pad.

9. The circuit board assembly according to claim 7, wherein when the first bottom plate is the package substrate, the circuit board assembly further comprises a first printed circuit board, and the package substrate is connected to the first printed circuit board.

10. The circuit board assembly according to any one of claims 1 to 9, further comprising a second chip and a plurality of second functional solder balls, wherein an array of second functional pads is disposed on the second chip, a plurality third pads are disposed on a second surface of the first chip away from the first bottom plate, the second functional pads are electrically connected to the corresponding third pads via the second functional solder balls, the second chip is provided with a second redundant pad position, the second redundant pad position is configured to dispose a redundant pad, the second redundant pad position comprises a third redundant pad position, and the third redundant pad position is disconnected from the first chip, to implement stress isolation between the first chip and the third redundant pad position.

11. An electronic device, comprising at least a display, a middle frame, a rear cover, and the circuit board assembly according to any one of claims 1 to 10, wherein the display and the rear cover are respectively located on two sides of the middle frame, and the circuit board assembly is located in a cavity enclosed by the display, the rear cover, and the middle frame.
